Europäisches Patentamt

European Patent Office

Office européen des brevets

(19)

(11) EP 0 336 479 B1

## (12) EUROPÄISCHE PATENTSCHRIFT

(45) Veröffentlichungstag und Bekanntmachung des Hinweises auf die Patenterteilung:
**29.01.1997 Patentblatt 1997/05**

(51) Int Cl.$^6$: **G01R 33/20**

(21) Anmeldenummer: **89200757.6**

(22) Anmeldetag: **24.03.1989**

(54) **Kernresonanz-Spektrometer**

NMR spectrometer

Spectromètre à résonance magnétique nucléaire

(84) Benannte Vertragsstaaten:
**DE FR GB NL**

(30) Priorität: **31.03.1988 DE 3811066**

(43) Veröffentlichungstag der Anmeldung:
**11.10.1989 Patentblatt 1989/41**

(73) Patentinhaber:
- **Philips Patentverwaltung GmbH**
  **22335 Hamburg (DE)**
  Benannte Vertragsstaaten:
  **DE**
- **Philips Electronics N.V.**
  **5621 BA Eindhoven (NL)**
  Benannte Vertragsstaaten:
  **FR GB NL**

(72) Erfinder: **Proksa, Roland**
**D-2000 Hamburg 20 (DE)**

(74) Vertreter: **Hartmann, Heinrich, Dipl.-Ing. et al**
**Philips Patentverwaltung GmbH,**
**Röntgenstrasse 24**
**22335 Hamburg (DE)**

(56) Entgegenhaltungen:
EP-A- 0 132 337          EP-A- 0 144 026
EP-A- 0 148 362          EP-A- 0 219 206
JP-A-62 070 741

- **MAGNETIC RESONANCE IN MEDICINE, Band 4, Nr. 5, Mai 1987, Seiten 407-421, New York, US; E.M. HAACKE: "The effects of finite sampling in spin-echo or field-echo magnetic resonance imaging"**
- **MEDICAL PHYSICS, Band 14, Nr. 4, Juli/August 1987, Seiten 640-645, New York, US; D.L. PARKER et al.: "Gibbs artifact removal in magnetic resonance imaging"**
- **Multirate Digital Signal Processing R.E.Crochiere & L.R.Rabiner 1983**

**Beschreibung**

Kernresonanz-Spektrometer

Die Erfindung betrifft ein Kernresonanz-Spektrometer, bei dem im Empfangszweig ein Analog-Digital-Wandler die Kernresonanzsignale bzw. ein in einen niedrigeren Frequenzbereich transponiertes Kernresonanzsignal in ein digitales Signal umsetzt und eine Fourier-Transformationsschaltung in einem Signalpfad hinter dem Analog-Digital-Wandler angeordnet ist. Ein Kernresonanz-Spektrometer dieser Art ist in der DE-OS 36 04 281 beschrieben. Das Kernresonanzsignal wird dabei in das Basisband umgesetzt und erst danach mittels eines Analog-Digital-Wandlers in eine Folge digitaler Datenworte umgewandelt. Wegen der Umsetzung in das Basisband ist eine Quadraturdemodulation erforderlich, wobei das Kernresonanzsignal mit einer Schwingung mit Lamorfrequenz gemischt wird, die den beiden Mischstufen mit einer Phasenverschiebung von 90° zugeführt wird.

Die beiden Mischstufen des bekannten Spektrometers müssen exakt symmetrisch aufgebaut sein, und die Phasenverschiebung zwischen den beiden Schwingungen muß exakt 90° betragen. Die Erfüllung dieser Forderung bei einer analog arbeitenden Mischstufe ist verhältnismäßig aufwendig. Ein weiterer Nachteil ist, daß die niedrigste Nutzfrequenz im Basisband so niedrig liegt, daß zur Verstärkung des Ausgangssignals der Mischstufen ein Gleichspannungsverstärker herangezogen werden muß. Durch Arbeitspunktverschiebung dieses Verstärkers ergibt sich eine störende Drift, die zu Rekonstruktionsfehlern bei der Weiterverarbeitung des Signals führt. Außerdem wirken sich im Basisband das niederfrequente 1/f-Rauschen (oft auch als Funkelrauschen bezeichnet) sowie Harmonische der Netzfrequenz besonders störend aus.

Aufgabe der Erfindung ist es, ein Spektrometer der eingangs genannten Art so auszugestalten, daß die aufwendigen analogen Komponenten entfallen können und die Rekonstruktion durch Drifteffekte nicht störend beeinflußt wird. Diese Aufgabe wird die im Anspruch 1 angegebenen Maßnahmen gelöst.

Bei der Erfindung erfolgt die Signalverarbeitung im wesentlichen digital. Drifteffekte spielen dabei keine Rolle. Derzeit gibt es jedoch noch keine Fourier-Transformationsschaltung, die es gestatten würde, ein analoges Signal in dem bei Kernspinuntersuchungen sich ergebenden Frequenzbereich (einige MHz) einer Fourier-Transformation in Echtzeit zu unterziehen. Derzeit ist dies mit wirtschaftlich vertretbarem Aufwand nur bis zu Frequenzen von einigen 100 KHz möglich.

Daher ist bei der Erfindung zwischen dem Analog-Digital-Wandler und der Fourier-Transformationsschaltung (mindestens) eine Abtastfrequenz-Reduzierschaltung vorgesehen, die die Abtastfrequenz so weit reduziert, daß die Fourier-Transformationsschaltung sie verarbeiten kann. Solche Abtastfrequenz-Reduzierschaltungen sind im Bereich der digitalen Signalverarbeitung an sich bekannt - vgl. das Buch: "MULTIRATE DIGITAL SIGNAL PROCESSING", R.E. CHROCHIERE & L.R. RABINER; PRENTICE HALL (US), 1983, Seiten 42-48 und 193-197. Die Reduzierung der Abtastfrequenz bedeutet, daß die Abtastfrequenz mit der das Kernresonanzsignal schlußendlich der Fourier-Transformationsschaltung zugeführt wird, wesentlich niedriger ist als die Frequenz des Signals selbst. Dies steht im Gegensatz zu den sonst üblichen Diskretisierungsverfahren, bei denen die Abtastfrequenz mindestens doppelt so hoch gewählt wird wie die Signalfrequenz, um Effekte der spektralen Faltung (Aliasing) zu vermeiden, die eine Signalverfälschung bewirken. Bei der Erfindung wird die Tatsache ausgenutzt, daß die Mittenfrequenz der Kernresonanzsignale bekannt ist und daß diese Kernresonanzsignale eine im Vergleich zu dieser Mittenfrequenz geringe Bandbreite haben. Die Abtastfrequenz läßt sich daher in Relation zur Signalfrequenz stets so wählen, daß das Nutzsignal durch die Unter-Abtastung (Undersampling) in einen Frequenzbereich außerhalb des Basisbandes und innerhalb eines durch die halbe Abtastfrequenz definierten periodischen Rasters transponiert werden kann. Das vorgeschaltete Digitalfilter bewirkt dabei, daß in diesen Bereich keine Störsignale aus einem anderen Frequenzbereich durch Faltung gelangen können.

Wenn die verringerte Abtastfrequenz um einen nicht ganzzahligen Faktor kleiner ist als die Frequenz des Signals am Ausgang des Digitalfilters, läßt sich, wie bereits erwähnt, stets erreichen, daß das Nutzsignalband nicht in das Basisband, d.h. in einen Frequenzbereich um die Frequenz Null herum, gefaltet wird. Infolgedessen benötigt ein derartiges Spektrometer nicht - wie das bekannte Spektrometer mit einem Quadraturdemodulator - zwei Signalpfade, in denen das Kernresonanzsignal vor der Fourier-Transformation verarbeitet wird, sondern nur einen einzigen.

Der Faktor, um den die Abtastfrequenz reduziert wird, kann nicht beliebig groß gewählt werden, weil sich daraus kaum noch zu erfüllende Forderungen für das Digitalfilter ergeben. Eine Möglichkeit, gleichwohl eine genügend große Reduzierung der Abtastfrequenz zu erreichen, besteht darin, in den Signalpfad hintereinander zwei der aus dem Digitalfilter und der Abtastfrequenz-Reduzierschaltung bestehende Schaltungen zu schalten. Eine andere Möglichkeit besteht demgegenüber darin, daß der Quotient aus der Frequenz des analogen Eingangssignals und der Abtastfrequenz größer ist als 0,5 und nicht ganzzahlig.

Hierbei wird also schon die Abtastfrequenz des Analog-Digital-Wandlers so niedrig gewählt, daß sich ein Undersampling und die damit verbundenen Aliasing-Effekte ergeben, durch die das analoge Eingangssignal digital in einen niedrigeren Frequenzbereich transponiert wird. Dadurch, daß der Quotient aus der Signalfrequenz und der Abtastfrequenz nicht ganzzahlig ist, wird vermieden, daß das Signal in das Basisband gelangt.

Die Erfindung wird nachstehend anhand der Zeichnung näher erläutert. Es zeigen:

Fig. 1 einen Kernspintomographen, bei dem die Erfindung einsetzbar ist, in schematischer Darstellung,

Fig. 2 das Blockschaltbild des Empfangsteils eines erfindungsgemäßen Spektrometers und

Fig. 3a bis 3g die Spektren an den Punkten a bis g der Anordnung nach Fig. 2.

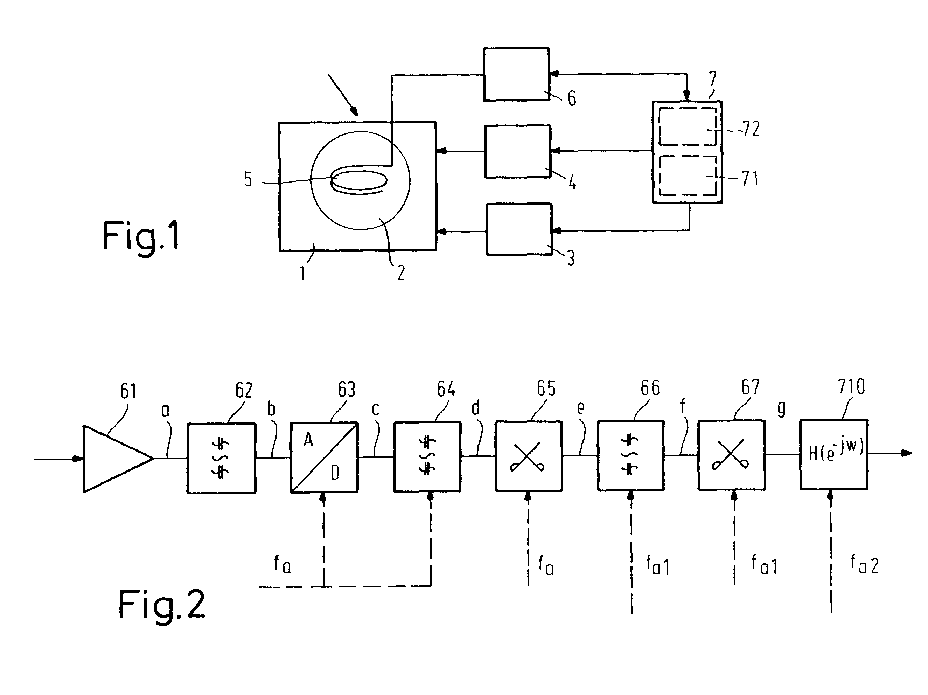

In Fig. 1 ist mit 1 eine Vorrichtung bezeichnet, die in einem Untersuchungsbereich 2 ein zur Zeichenebene senkrecht verlaufendes homogenes und stationäres Magnetfeld von z.B. 0,21 T erzeugt und die bei Bedarf auch magnetische Gradientenfelder erzeugt, d.h. Magnetfelder, die in der gleichen Richtung verlaufen, wie das homogene, stationäre Magnetfeld, deren Stärke sich jedoch linear in Richtung des Magnetfeldes oder in einer dazu senkrechten Richtung ändert. Die Vorrichtung 1 ist zu diesem Zweck mit einem Generator 3 gekoppelt, der das stationäre Magnetfeld erzeugt und mit einem Generator 4, der die Ströme für die verschiedenen magnetischen Gradientenfelder liefert. Außerdem ist eine Hochfrequenzspule 5 vorgesehen, die im Sendebetrieb ein zum stationären Magnetfeld senkrechtes, hochfrequentes Magnetfeld erzeugt und im Empfangsbetrieb die im Untersuchungsbereich entstehenden Kernresonanzsignale aufnimmt und die an den Ausgang eines Spektrometers 6 angeschlossen ist. Das Spektrometer liefert im Sendebetrieb die Hochfrequenzenergie für die Hochfrequenzspule 5 und verarbeitet im Empfangsbetrieb die in dieser Spule induzierten Kernresonanzsignale.

Die Generatoren 3 und 4 und das Spektrometer 6 werden durch eine digitale Zentraleinheit 7 gesteuert, die zu diesem Zweck einen Steuerteil 71 enthält. Außerdem umfaßt die digitale Zentraleinheit einen Verarbeitungsteil 72, der die vom Spektrometer 6 gelieferten Daten verarbeitet und daraus die Kernmagnetisierungsverteilung im Untersuchungsbereich 2 rekonstruiert. Diese Verarbeitung umfaßt u.a. auch eine Fourier-Transformation, die in Echtzeit erfolgt.

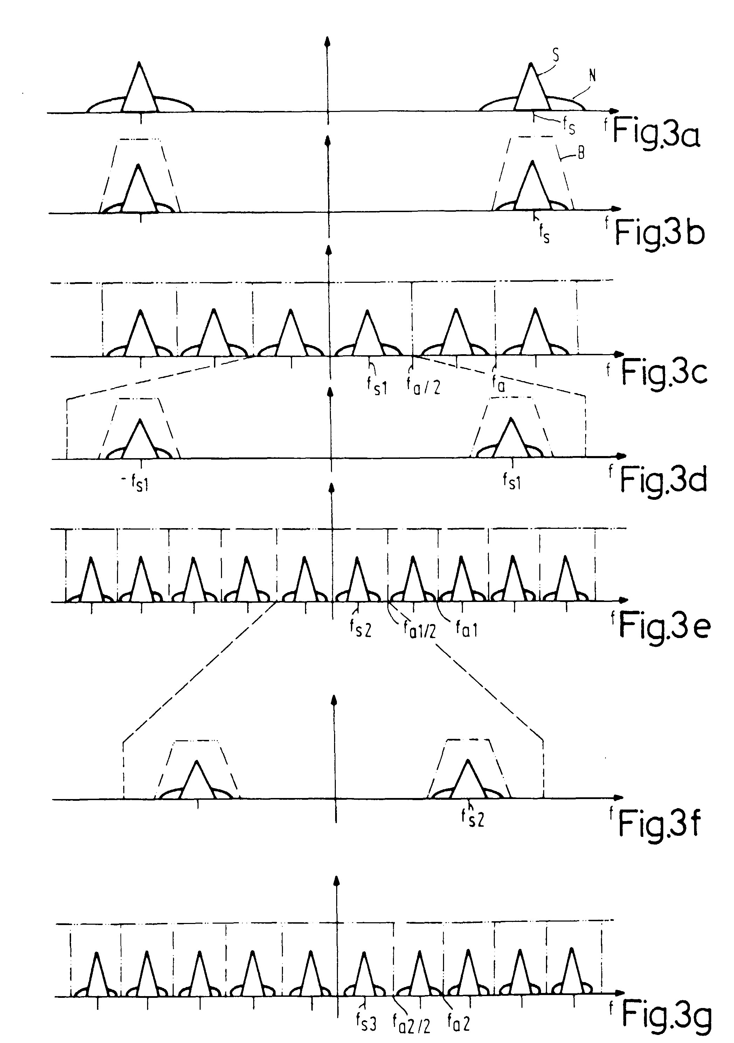

Wie sich aus dem Blockschaltbild des Spektrometers in Fig. 1 ergibt, wird das von der Hochfrequenzspule 5 aus dem Untersuchungsbereich empfangene Signal einem Vorverstärker 61 zugeführt. Bei einer Induktion des homogenen stationären Magnetfeldes von 0,21 T liegt der Mittelwert der Frequenz des Kernresonanzsignals etwa bei 9 MHz. Die Bandbreite hängt von der Größe des Gradienten des während der Aufnahme des Kernresonanzsignals eingeschalteten magnetischen Gradientenfeldes ab und von der Größe des Untersuchungsbereichs. Im allgemeinen ist die Bandbreite aber nicht größer als 60 KHz. Das Spektrum am Ausgang a des Vorverstärkers 61 ist in Fig. 3a dargestellt, in der das schematisch angedeutete Spektrum des Kernresonanzsignals mit S und das wesentlich breitere Rauschspektrum mit N bezeichnet ist.

Das Ausgangssignal des Vorverstärkers wird über einen analogen Bandpaß 62 mit einer Mittenfrequenz von 9 MHz einem Analog-Digital-Wandler 63 zugeführt. Das in Fig. 3b dargestellte Spektrum des Signals am Ausgang b des analogen Bandpasses 62 entspricht im wesentlichen dem in Fig. 3a dargestellten Spektrum, wobei lediglich das Rauschband durch die Wirkung des Bandpasses, dessen Übertragungsfunktion in Fig. 3b mit F schematisch und gestrichelt angedeutet ist, beschnitten worden ist.

Der Analog-Digital-Wandler 63 setzt das analoge Eingangssignal in eine Folge von digitalen Datenworten mit einer Länge von 12 Bits um; bei den üblichen Anforderungen an die Signaldynamik könnte aber auch eine Wortlänge von 10 Bit ausreichen. Die Verstärkung des Vorverstärkers 61 muß so gewählt sein, daß der Rauschanteil des Kernresonanzsignals größer ist als eine Quantisierungsstufe des Wandlers 63. Die Abtastfrequenz $f_a$, mit der das analoge Kernresonanzsignal abgetastet wird, beträgt 7,2 MHz. Durch diese Abtastung ergibt sich eine Umsetzung der Signalfrequenz $f_s$ von einem Wert von 9 MHz auf einen Wert $f_{s1}$ von 1,8 MHz, der sich in einem Frequenzbereich von $-f_{a/2}$ bis $+f_{a/2}$ (3,6 MHz) befindet, der sich mit der Periode $f_a$ periodisch wiederholt. Um zu verhindern, daß Störspannungen von außerhalb des Nutzfrequenzbereiches auf die Frequenz $f_{s1}$ und in deren Nähe umgesetzt werden, muß der Bandpaß 62 so ausgelegt sein, daß alle Frequenzkomponenten in einem Abstand von mehr als 1,8 MHz von der Frequenz $f_s$ möglichst weitgehend unterdrückt werden.

Fig. 3c zeigt das Spektrum am Ausgang des Analog-Digital-Wandlers 63. Die Frequenz $f_{s1} = 1,8$ MHz ergibt sich aus dem Betrag der Differenz $f_s - f_a$. Es gibt noch weitere Komponenten, die jeweils symmetrisch zur Abtastfrequenz $f_a$ und deren Oberwellen liegen und die im bezug auf diese Abtastfrequenz die gleiche Lage haben, wie das Signal mit der Frequenz $f_{s1}$ im bezug auf die Frequenz Null.

Das Ausgangssignal des Analog-Digital-Wandlers 63 wird einem digitalen Filter 64 mit Bandpaßcharakteristik zugeführt, das mit derselben Abtastfrequenz arbeitet wie der Analog-Digital-Wandler 63. Die Mittenfrequenz dieses Bandpasses liegt bei der Frequenz $f_{s1}$ (1,8 MHz), und die Übertragungsfunktion dieses Filters ist so gewählt, daß das Rauschen jenseits des Nutzfrequenzbandes unterdrückt wird, um zu verhindern, daß diese Rauschanteile durch die nachfolgende Verarbeitung des Signals in den Signalfrequenzbereich gefaltet werden. Das Spektrum am Ausgang d dieses Filters ist in Fig. 3d dargestellt (in einem anderen Frequenzmaßstab als die Fig. 3a bis 3c). Das Ausgangssignal des Digitalfilters wird einer ersten Abtastfrequenz-Reduzierschaltung 65 zugeführt. Aufgabe dieser Schaltung ist es, nur jedes p-te Datenwort der weiteren Verarbeitung zuzuführen, wobei p ein ganzzahliger Faktor ist, der in diesem Falle 5 beträgt. Infolgedessen ist der Datenstrom am Ausgang e im Verhältnis zu dem Datenstrom am Eingang dieser Schaltung auf ein Fünftel (= 1/p) reduziert, d.h. am Ausgang der Schaltung 65 erscheinen 1,44 Mio.-Datenworte pro Sekunde.

Eine derartige Abtast- und Reduzierschaltung kann auf verschiedene Weise realisiert werden. Sie kann beispielsweise eine Torschaltung und einen Zähler umfassen, der Impulse mit der Abtastfrequenz $f_a$ zählt und nach jedem fünften Impuls rückgesetzt wird und dabei die Torschaltung öffnet, so daß das in diesem Augenblick anliegende Datenwort passieren kann. Ebenso ist es möglich, die Taktfrequenz dem Tor über einen Frequenzteiler zuzuführen.

Fig. 3e zeigt das Spektrum im Ausgang der Schaltung 65. Durch die Abtastfrequenzreduzierung auf ein Fünftel des Wertes $f_a$ ergibt sich die neue Abtastfrequenz $f_{a1}$ = 1,44 MHz, was zur Folge hat, daß sich das Spektrum mit der Periodizität von $f_{a1}$ wiederholt. Die Signalfrequenz wird nach der Faltung ebenfalls um den Faktor 5 reduziert, so daß die Signalfrequenz $f_{s2}$ am Ausgang der Schaltung 65 360 KHz beträgt ($f_{s1}/p$).

Die Reduzierung der Abtastfrequenz entspricht einer erneuten Unterabtastung - diesmal im digitalen Bereich - und hat zur Folge, daß Frequenzen, die zuvor weit von der Nutzfrequenz ablagen, in den Nutzfrequenzbereich gefaltet werden können. So wird beispielsweise eine Frequenzkomponente am Ausgang c des Analog-Digital-Wandlers 63, die vom Träger $f_{s1}$ einen Abstand von 1,08 MHz hat, durch die Unterabtastung mit der Schaltung 65 genau auf die Frequenz $f_{s2}$ = 360 KHz gefaltet. Wenn sich in diesem Frequenzbereich vor der Unterabtastung noch Rauschsignale befänden, würde das Signal/Rauschverhältnis also verschlechtert. Um dies zu vermeiden, muß der Bandpaß 64 bei einer Bandbreite von 720 KHz (d.h. jeweils im Abstand von 360 KHz von $f_{s1}$) möglichst alle Signale unterdrücken. Allerdings würde es nicht schaden, wenn die Unterdrückung erst bei geringfügig weiter außerhalb liegenden Frequenzen gelänge. Es würden dann zwar aus dem Band von 0 bis $f_a$ (Fig. 3c) schon Komponenten in das Band von 0 bis $f_{a1}$ gefaltet, doch würden die gefalteten Komponenten an den Rändern des Bereiches 0 bis $f_{a1}$ liegen, wo sich ebenfalls nur Rauschen, aber nicht das Nutzsignal befindet.

Aus dem Vorstehenden wird deutlich, daß es von besonderem Vorteil ist, daß die Frequenzen $f_{s1}$ und $f_{s2}$ immer genau in der Mitte des Bereiches von 0 bis $F_{a/2}$ bzw. von 0 bis $F_{a1/2}$ liegen. Wenn die Signalfrequenzen zu einer Seite hin verschoben wären, würden die Anforderungen an die Filter 62 und 64 steigen.

Es läßt sich zeigen, daß die Frequenz $f_{s1}$ immer dann die günstige Mittellage einnimmt, wenn die Beziehung

$$f_a = \frac{4}{4n+1} f_s \qquad (1)$$

erfüllt ist. n muß dabei eine positive ganze Zahl sein. Die Signalfrequenz hinter dem Analog-Digital-Wandler hat dann den Wert $f_{s1} = f_s - {}_nf_a$. Beim Ausführungsbeispiel ist n = 1.

Eine ähnlich günstige Lage der Frequenz $f_{s1}$ ergibt sich, wenn die Beziehung gilt

$$f_a = \frac{4}{4n-1} f_s \qquad (2)$$

Allerdings befindet sich bei einer Bemessung der Abtastfrequenz entsprechend Gleichung (2) das Nutzfrequenzband nach der Abtastung in einer Kehrlage, d. h. die Frequenzkomponenten, die vor der Abtastung oberhalb von $f_s$ lagen, liegen nach der Abtastung unterhalb von $f_{s1}$ (und umgekehrt). Dies könnte zur Folge haben, daß die Kernmagnetisierungsverteilung seitenverkehrt rekonstruiert wird. Dies läßt sich aber dadurch vermeiden, daß durch eine weitere geeignete Unterabtastung dieses Frequenzband erneut in die Kehrlage gebracht wird, so daß es wieder die Originallage einnimmt. Die seitenverkehrte Abbildung könnte aber auch durch die auf die Fourier-Transformation folgende Datenverarbeitung softwaremäßig wieder rückgängig gemacht werden.

Geringfügige Abweichungen der Abtastfrequenz $f_a$ gegenüber den in den Gleichungen 1 und 2 definierten Werten sind zulässig, jedoch dürfen diese nicht soweit gehen, daß der Quotient $f_s/f_a$ ganzzahlig wird; in diesem Fall würde das Nutzfrequenzband durch die Unterabtastung symmetrisch zur Frequenz f = 0 liegen, wobei die negativen Frequenzen in den positiven Frequenzbereich gefaltet würden. Um in diesem Fall eine Rekonstruktion zu ermöglichen, müßte das Kernresonanzsignal - ähnlich wie bei einem Quadraturdemodulator - in zwei parallelen Zweigen phasenverschoben verarbeitet werden.

Die gleiche ungünstige Bedingung ergäbe sich beispielsweise dann, wenn die Abtastfrequenz in der Schaltung 64 um einen Faktor p = 4 reduziert würde. Sie würde dann 1,8 MHz betragen, d.h. genauso groß sein, wie die (reduzierte) Signalfrequenz $f_{s1}$, was zur Folge hätte, daß $f_{s2}$ bei Null liegen würde.

Die günstigste Lage ergibt sich wiederum aus den Gleichungen 1 und 2, wobei lediglich $f_s$ durch $f_{s1}$ und $f_a$ durch $f_{a1}$ ersetzt werden muß. Wie leicht nachzuprüfen ist, genügt die bei p = 5 resultierende Abtastfrequenz $f_{a1}$ = 1,44 MHz der Gleichung (1) für n = 1.

Das Ausgangssignal der Abtastreduzierschaltung 64 wird über ein weiteres Digitalfilter 66 mit Bandpaßcharakteristik einer weiteren Abtast- und Reduzierschaltung 67 zugeführt. Die Abtastfrequenz des Filters 66 beträgt $f_{a1}$ (1,44 MHz). Die Mittenfrequenz des Filters liegt bei 360 KHz und seine Bandbreite beträgt etwa 72 KHz. Am Ausgang des Filters ergibt sich somit das - gegenüber Fig. 3d und e wiederum im vergrößerten Maßstab dargestellte - Frequenzspektrum der Fig. 3f.

Die Abtastfrequenz-Reduzierschaltung 67 verringert den Datenstrom noch einmal auf ein Fünftel, d.h. von den 1,44 Mio.-Datenworten, die am Eingang der Schaltung 77 pro Sekunde auftreten, wird nur jedes fünfte Datenwort verarbeitet, d.h. also 288.000 Datenworte pro Sekunde. Die Abtastfrequenz am Ausgang der Schaltung 67 ist somit auf einen Wert $f_{a2} = 288$ KHz reduziert. Dieser Wert erfüllt wiederum im Hinblick auf die Signalfrequenz $f_{s2}$ die Bedingung nach Gleichung 1, wenn $f_s$ durch $f_{s2}$ und $f_a$ durch $f_{a2}$ ersetzt wird. Durch die Reduzierung der Abtastfrequenz reduziert sich die Signalfrequenz $f_{s2}$ ebenfalls auf ein Fünftel, d.h. von 360 KHz auf 72 KHz. Das resultierende Spektrum am Ausgang der Schaltung 67 ist in Fig. 3g dargestellt.

Das Ausgangssignal der Schaltung 67 wird einer Fourier-Transformationsschaltung 710 zugeführt, die Teil der Verarbeitungsschaltung 72 ist. Die Taktfrequenz für das Eingangssignal ist dabei mit der Frequenz $f_{a2}$ identisch, so daß während des zwischen 2 und 30 ms dauernden Abtastintervalls, während dessen das Kernresonanzsignal in eine Folge von Datenworte umgesetzt wird, einige Tausend Datenworte in der Schaltung 710 verarbeitet werden, die daraus für eine halb so große Anzahl von diskreten Frequenzen mittels einer Fourier-Transformation die Spektralanteile nach Betrag und Phase berechnet. Diese Schaltung kann ein System von mehreren Transputern enthalten, die die Abtastwerte gleichzeitig verarbeiten. Das auf diese Weise rekonstruierte Frequenzspektrum erfaßt (vgl. Fig. 3g) den gesamten Frequenzbereich von 0 bis $f_{a2/2}$ (144 KHz). Das für die weitere Verarbeitung wesentliche Nutzsignalband ist jedoch wesentlich schmaler und beträgt beispielsweise nur 20 KHz. Infolgedessen werden von den Ausgangssignalen der Schaltung 710 nur diejenigen für die weitere Verarbeitung herangezogen, die diesem Frequenzband entsprechen, die also in dem angenommenen Beispiel Frequenzen zwischen 62 KHz und 82 KHz zugeordnet sind.

Vorstehend wurde ein Kernresonanz-Spektrometer beschrieben, bei dem die Kernresonanzsignale direkt dem Analog-Digital-Wandler zugeführt wurden. Wenn diese Signale aber eine Frequenz haben, die höher ist als die vom Analog-Digital-Wandler verarbeitbare Frequenz, müssen sie vor der Digitalisierung zunächst mittels einer Mischstufe in einen niedrigeren Frequenzbereich transportiert werden.

**Patentansprüche**

1. Kernresonanz-Spektrometer, bei dem im Empfangszweig ein Analog-Digital-Wandler die Kernresonanzsignale bzw. ein in einen niedrigeren Frequenzbereich transponiertes Kernresonanzsignal in ein digitales Signal umsetzt und eine Fourier-Transformationsschaltung in einem Signalpfad hinter dem Analog-Digital-Wandler angeordnet ist, dadurch gekennzeichnet, daß im Signalpfad zwischen dem Analog-Digital-Wandler (63) und der Fourier-Transformationsschaltung (710) mindestens eine Schaltung angeordnet ist, die aus einem Digitalfilter (64) mit Bandpaß-Charakteristik und einer Abtastfrequenz-Reduzierschaltung (65) besteht, deren Ausgangssignale gegenüber ihren Eingangssignalen einen um einen ganzzahligen Faktor verringerte Abtastfrequenz aufweisen, und daß die verringerte Abtastfrequenz ($f_{a1}$; $f_{a2}$) um einen nicht ganzzahligen Faktor kleiner ist, als die Frequenz des Signals ($f_{s1}$; $f_{s2}$) am Ausgang des Digitalfilters.

2. Spektrometer nach Anspruch 1, dadurch gekennzeichnet, daß der Quotient aus der Frequenz des analogen Eingangssignals ($f_s$) des Analog-Digital-Wandlers (63) und seine Abtastfrequenz ($f_a$) größer ist als 0,5 und nicht ganzzahlig.

3. Spektrometer nach einem der vorhergehenden Ansprüche, dadurch gekennzeichnet, daß zwischen der Frequenz $f_s$ des Eingangssignals der Abtastfrequenz-Reduzierschaltung und/oder des Digitalfilters und der Abtastfrequenz $f_a$ die Beziehung

$$f_a/f_s = 4/(4\,n + a)$$

besteht, wobei n eine positive ganze Zahl und a entweder + 1 oder - 1 ist.

**Revendications**

1. Spectromètre à résonance magnétique nucléaire, un convertisseur analogique/numérique convertissant les signaux de résonance magnétique nucléaire ou un signal de résonance magnétique nucléaire transposé dans une plage de fréquences inférieure en un signal numérique dans la branche réceptrice et un circuit de transformation de Fourier étant disposé dans l'acheminement du signal derrière le convertisseur analogique/numérique, caractérisé en ce que, dans l'acheminement du signal, entre le convertisseur analogique/numérique (63) et le circuit de transformation de Fourier (710) est disposé au moins un circuit qui se compose d'un filtre numérique (64) avec une caractéristique de bande passante et d'un circuit de réduction de la fréquence de balayage (65) dont les signaux de sortie présentent par rapport à leurs signaux d'entrée une fréquence de balayage réduite d'un facteur entier et en ce que la fréquence de balayage réduite ($f_{a1}$;$f_{a2}$) est inférieure d'un facteur non entier à la fréquence du signal ($f_{s1}$;$f_{s2}$) à la sor-

tie du filtre numérique.

**2.** Spectromètre selon la revendication 1,
caractérisé en ce que le quotient de la fréquence du signal d'entrée analogique ($f_s$) du convertisseur analogique/numérique (63) et sa fréquence de balayage ($f_a$) est supérieur à 0,5 et n'est pas un nombre entier.

**3.** Spectromètre selon une des revendications précédentes,
caractérisé en ce qu'entre la fréquence $f_s$ du signal d'entrée du circuit de réduction de la fréquence de balayage et/ou le filtre numérique et la fréquence de balayage $f_a$, l'équation :

$$f_a/f_s = 4/(4n + a)$$

est applicable, où n désigne un nombre entier positif et a soit +1 ou -1.

**Claims**

**1.** A magnetic resonance spectrometer in which an analog-to-digital converter in the receiving branch converts the magnetic resonance signals, or a magnetic resonance signal transposed to a lower frequency range, into a digital signal, and in which a Fourier transformation circuit is arranged in a signal path subsequent to the analog-to-digital converter, characterized in that in the signal path between the analog-to-digital converter (63) and the Fourier transformation circuit (710) there is arranged at least one circuit which consists of a digital filter (64), having a bandpass characteristic, and a sampling frequency reducing circuit (65), the output signals of which have a sampling frequency which has been reduced by an integer factor with respect to their input signals, and that the reduced sampling frequency ($f_{a1}$; $f_{a2}$) is a non-integer factor lower than the frequency of the signal ($f_{s1}$; $f_{s2}$) on the output of the digital filter.

**2.** A spectrometer as claimed in Claim 1, characterized in that the quotient of the frequency of the analog input signal ($f_s$) of the analog-to-digital converter (63) and its sampling frequency ($f_a$) is non-integer and larger than 0.5.

**3.** A spectrometer as claimed in any one of the preceding Claims, characterized in that the relation $f_a/f_s = 4/(4n + a)$ exists between the frequency $f_s$ of the input signal of the sampling frequency reducing circuit and/or the digital filter and the sampling frequency $f_a$, where n is a positive integer and a is either + 1 or -1.

Fig.1

Fig.2

Fig.3a

Fig.3b

Fig.3c

Fig.3d

Fig.3e

Fig.3f

Fig.3g